# EUROPEAN PATENT APPLICATION

(11) **EP 1 939 946 A1**
(43) Date of publication of application: **02.07.2008**
(21) Application number: 06810907.3
(22) Date of filing: 29.09.2006
(51) Int. Cl.: H01L 31/04

(54) **CIS-TYPE THIN FILM SOLAR BATTERY MODULE AND PROCESS FOR PRODUCING THE SAME**

(30) Priority: 29.09.2005 JP 2005284058
(71) Applicant: Showa Shell Sekiyu Kabushiki Kaisha, Minato-ku Tokyo 135-8074 (JP)
(72) Inventor: KUSHIYA, Katsumi, (JP)
(74) Representative: HOFFMANN EITLE
(86) International application number: PCT/JP2006/319527
(87) International publication number: WO 2007/037406

(57) **Abstract**

The tin-free air side of each of float-processed soda-lime float glass substrates is quickly and accurately distinguished, and the substrates are arranged, with the air sides facing upward. CIS based thin-film photovoltaic devices are formed on the air sides to improve conversion efficiency and yield and reduce production cost.

A surface of a glass substrate is irradiated with ultraviolet lights. When fluorescence occurs, this side is judged to be the tin-containing float side B (P1) and a tin containment mark is put thereon (P2). When the upper side is the air side A not bearing a tin containment mark, this substrate is subjected as it is to a cleaning/drying step and to the formation of a CIS based thin-film photovoltaic device on the air side A. When the upper side is the float side B, this substrate is turned over (P3) and then subjected to a cleaning/drying step (P4) and to the formation of a CIS based thin-film photovoltaic device on the upper side, i.e., the air side A (P5).

## Description

### TECHNICAL FIELD

The present invention relates to a structure of a CIS based thin-film photovoltaic module and a process for producing the structure. In particular, the invention relates to a structure of a CIS based thin-film photovoltaic module comprising a float glass substrate and a photovoltaic device formed on the tin-free air side of the substrate, and to a process for producing this structure.

### BACKGROUND ART

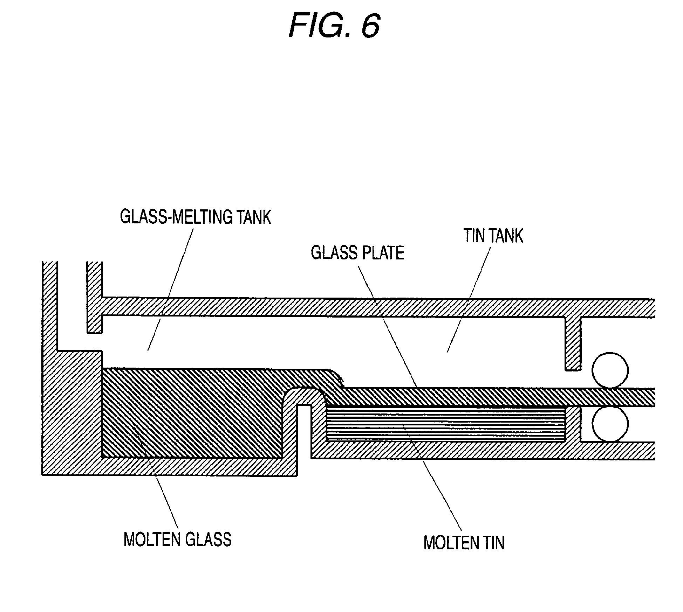

In producing CIS based thin-film photovoltaic modules, CIS based thin-film photovoltaic devices are formed on flat glasses produced with the float process as a substrate, from the standpoint of relationship between availability of large-area size and reduction of the production cost. The float-process produced with the flat glass as a substrate comprises causing a molten glass to float on molten tin and regulating the floating glass so as to have a given thickness, as shown in Fig. 6. Because of this, the glass substrate has such properties that the float side of the substrate contains tin and the air side thereof does not contain tin. It has been thought that whichever side, between the float side and the air side, of the float-processed soda-lime float glass substrate is used as the side where a CIS based thin-film photovoltaic device is formed, this does not result in a significant difference in solar-cell characteristics, etc.

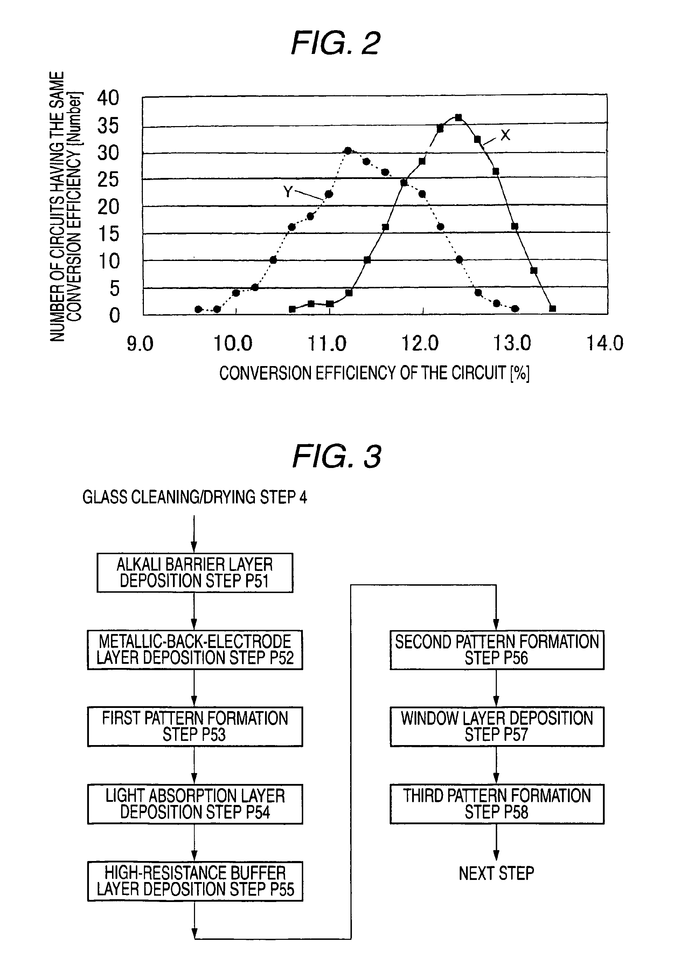

The present applicant found that in the case where a CIS based thin-film photovoltaic device is formed on the tin-free air side of a float-processed soda-lime float glass substrate, a higher conversion efficiency is obtained than in the case where a CIS based thin-film photovoltaic device is formed on the tin-containing float side of the float-processed soda-lime float glass substrate, as shown in Fig. 2.

A known technique for distinguishing the float side of a glass substrate for plasma displays is a method in which the glass is irradiated with ultraviolet lights and the visible light emitted due to the irradiation from the tin present on the float side is detected (see, for example, patent document 1). Float glasses are used as glass substrates for plasma displays, and plasma displays employ a silver material as display electrodes and data electrodes. As a result, in the case where a silver material for forming a display electrode and a data electrode is applied to the float side of a glass substrate, oxidation-reduction reactions occur between the tin present on the float side of the float glass and silver ions of the silver material to yield an Ag-Sn colloid and this colloid formation yellows the glass substrate and considerably impairs the quality of images displayed. For preventing this, it is required not to form an electrode on the float side of the float glass. Because of this, the method of distinguishing the float side of a float glass substrate described in patent document 1 is one which utilizes the fact that the float side contains tin and which comprises irradiating the float glass substrate with ultraviolet lights and detecting as visible light the fluorescence from the tin present on the float side to distinguish the float side.

When a float-processed soda-lime float glass is used as a substrate and a CIS based thin-film photovoltaic device is formed on the tin-containing float side, then there is a problem that the tin diffuses into the light absorption layer of the device to form an unsuitable and defective chalcopyrite structure, making it impossible to obtain a high-efficient CIS based thin-film photovoltaic device. Because of this, in the process of the invention for producing a CIS based thin-film photovoltaic device, a simple and accurate operation for distinguishing the float side from the air side is conducted. For the operation for distinguishing the float side from the air side in a glass substrate for a CIS based thin-film photovoltaic device, use is made of the known method for distinguishing the float side of a glass substrate for plasma displays. In the process for producing a CIS based thin-film photovoltaic device, however, the operation for distinguishing the float side from the air side in a glass substrate is followed by the cleaning of the glass substrate and the formation of a CIS based thin-film photovoltaic device. Because of this, when glass substrates which have undergone the operation for distinguishing the float side from the air side are not uniform in glass side arrangement, it is necessary to arrange the substrates so that the same side faces in one direction. Furthermore, there is a possibility that glass side reversal might occur after the operation for distinction due to later treatments, storage, etc. In this case, the float side and the air side are not considered to have been clearly distinguished from each other. It is hence indispensable that the results of distinction between the float side and the air side of a glass substrate should be left in a distinguishable form on the glass substrate quickly and accurately.

Patent Document 1: JP-A-2004-51436

### DISCLOSURE OF THE INVENTION

### PROBLEMS THAT THE INVENTION IS TO SOLVE

The invention eliminates the problems described above. An object of the invention is to quickly and accurately distinguish the tin-free air side of each of float-processed soda-lime float glasses, put a tin contained distinction mark on the tin-containing float side, arrange the float-processed soda-lime float glasses so that the tin-free air sides of the glasses face any one of upward, downward, leftward, and rightward directions, and form CIS based thin-film photovoltaic devices on the air sides to thereby improve the conversion efficiency and yield of the CIS based thin-film photovoltaic devices and reduce the production cost.

### MEANS FOR SOLVING THE PROBLEMS

(1) The invention provides a CIS based thin-film photovoltaic module which forms a CIS (CuInSe₂) type thin-film photovoltaic device on a soda-lime float glass which is a float glass and has surfaces comprising an air side containing no tin and a float side containing tin, wherein the photovoltaic device is formed on the air side of the soda-lime float glass.

(2) The invention provides a process for producing a CIS based thin-film photovoltaic module, which comprises forming through film deposition a CIS (CuInSe₂) based thin-film photovoltaic device on a soda-lime float glass which is a float glass and has surfaces comprising an air side containing no tin and a float side containing tin, wherein the photovoltaic device is formed on the air side of the soda-lime float glass.

(3) The invention provides the process for producing a CIS based thin-film photovoltaic module as described under (2) above, wherein the tin-free air side of the soda-lime float glass is distinguished with a glass surface distinction device which forms a judgment as to whether each surface of the soda-lime float glass contains tin or not, and the CIS based thin-film photovoltaic device is formed on the air side.

(4) The invention provides the process for producing a CIS based thin-film photovoltaic module as described under (3) above, wherein the tin-containing float side of the soda-lime float glass is distinguished with the glass surface distinction device; a tin containment mark indicating that tin is contained is put on the float side with a tin containment mark placer (or a mark indicating that no tin is contained is put on the tin-free air side of the soda-lime float glass) quickly and accurately and the CIS based thin-film photovoltaic device is formed on the tin-free air side of the soda-lime float glass.

(5) The invention provides the process for producing a CIS based thin-film photovoltaic module as described under (3) or (4) above, wherein the glass surface distinction device irradiates each surface of the soda-lime float glass with ultraviolet lights having a wavelength of 200-300 nm, preferably about 250-300 nm, which cause fluorescence in the presence of tin and do not penetrate the glass (are absorbed), and wherein when the irradiation with the ultraviolet lights results in fluorescence (the amount of tin fluorescence is large (not smaller than a given value)), then the device judges this surface to be the side where the CIS based thin-film photovoltaic device is not to be formed, and wherein when the ultraviolet irradiation does not result in fluorescence (the amount of tin fluorescence is small (not larger than a given value)), then the device judges this surface to be the side wherein the CIS based thin- film photovoltaic device is to be formed.

(6) The invention provides the process for producing a CIS based thin-film photovoltaic module as described under (3) or (4) above wherein the tin containment mark is a sign, e.g., a mark or a scar, which withstands physical or chemical treatments in later steps and is mechanically or visually distinguishable, and is put on a given position in a peripheral part of the surface of the soda-lime float glass with an ink or a coating material, with a laser or a glass scriber (diamond), or by sandblasting or the like.

(7) The invention provides the process for producing a CIS based thin-film photovoltaic module as described under (3), (4), or (5) above, wherein a given number of soda-lime float glasses cut into a given size are conveyed one by one to the glass surface distinction device, the soda-lime float glasses having been stacked so that the tin-free air side of each glass in principle faces in any one of upward, downward, leftward, and rightward directions (e.g., upward direction) which is the side where a CIS based thin-film photovoltaic device is to be formed (hereinafter referred to as deposition side), the tin-containing float side of each soda-lime float glass is distinguished by the glass surface distinction device, wherein when that side of the soda-lime float glass on which a CIS based thin-film photovoltaic device is not to be formed (hereinafter referred to as non-deposition side; e.g., the lower side) was judged to be the float side by the glass surface distinction device, then this soda-lime float glass is conveyed to next steps (steps for forming a CIS based thin-film photovoltaic device), and wherein when the deposition side (e.g., the upper side) of the soda-lime float glass was judged to be the float side by the glass surface distinction device, then this soda-lime float glass is reversed by rotating the glass by 180° (vertically or horizontally) and conveyed to the next steps or is removed from the conveyance line.

(8) The invention provides the process for producing a CIS based thin-film photovoltaic module as described under (3), (4), (5), or (6) above, wherein a given number of soda-lime float glasses cut into a given size are conveyed one by one to the glass surface distinction device, the soda-lime float glasses having been stacked so that the tin-free air side of each glass in principle faces in any one of upward, downward, leftward, and rightward directions (e.g., upward direction) which is the side where a CIS based thin-film photovoltaic device is to be formed (hereinafter referred to as deposition side), wherein when that side of the soda-lime float glass on which a CIS based thin-film photovoltaic device is not to be formed (hereinafter referred to as non-deposition side; e.g., the lower side) was judged to be the float side by the glass surface distinction device, then a tin containment mark is put on the non-deposition side (e.g., the lower side) of the soda-lime float glass (or a mark indicating that no tin is contained is put on the tin-free surface of the soda-lime float glass) by the tin containment mark placer, wherein when the deposition side (e.g., the upper side) of the soda-lime float glass was judged to be the float side by the glass surface distinction device, then a tin containment mark is put on the deposition side (e.g., the upper side) of the soda-lime float glass (or a mark indicating that no tin is contained is put on the tin-free surface of the soda-lime float glass) by the tin containment mark placer, wherein when the non-deposition side (e.g., the lower side) of the soda-lime float glass bears the tin containment mark, then this soda-lime float glass is conveyed to next steps (a cleaning step and steps for forming a CIS based thin-film photovoltaic device), and wherein when the deposition side (e.g., the upper side) of the soda-lime float glass bears the tin containment mark, then this soda-lime float glass is reversed by rotating the glass by 180° (vertically or horizontally) and conveyed to the next steps or is removed from the conveyance line.

(9) The invention provides the process for producing a CIS based thin-film photovoltaic module as described under (8) above, wherein the soda-lime float glass which has been removed from the conveyance line is reversed by rotating the glass by 180° (vertically or horizontally) and stacked.

(10) The invention provides the process for producing a CIS based thin-film photovoltaic module as described under (2) or (3) above, wherein the CIS based thin-film photovoltaic device is formed by steps which comprise, in the following order, an alkali barrier layer deposition step, a metallic-back-electrode layer deposition step, a first pattern formation step, a light absorption layer deposition step, a high-resistance buffer layer deposition step, a second pattern formation step, a window layer deposition step, and a third pattern formation step.

(11) The invention provides the process for producing a CIS based thin-film photovoltaic module as described under (10) above, wherein in part of the steps for forming the CIS based thin-film photovoltaic device, a film is deposited on the air side of the soda-lime float glass while keeping the air side in any one state selected from the states of facing upward, facing downward, facing in a lateral direction, and facing in a lateral direction inclined at a given angle.

### ADVANTAGES OF THE INVENTION

According to the invention, the tin-free air side of each of float-processed soda-lime float glasses is quickly and accurately distinguished and a tin containment distinction mark is put on the tin-containing float side. The float-processed soda-lime float glasses are arranged so that the tin-free air sides thereof face any one of upward, downward, leftward, and rightward directions, and CIS based thin-film photovoltaic devices are formed on the air sides. Thus, the conversion efficiency and yield of the CIS based thin-film photovoltaic modules are improved and the cost of production thereof can be reduced.

### BEST MODE FOR CARRYING OUT THE INVENTION

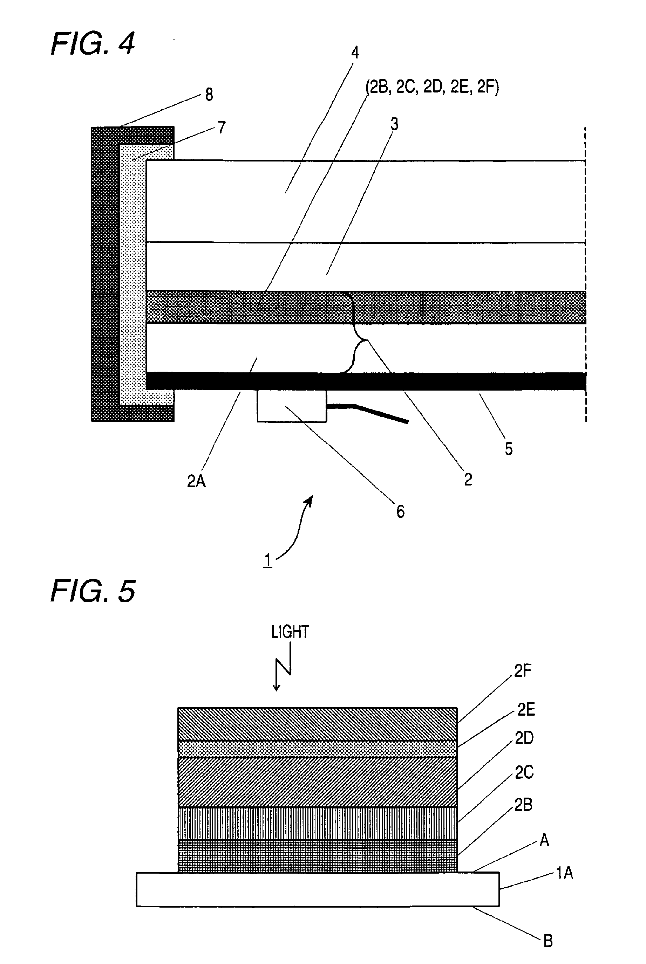

Embodiments of the invention will be explained below.
The invention relates to a CIS based thin-film photovoltaic device 2 or a process for producing the same. In particular, the invention relates to a CIS based thin-film photovoltaic module comprising a float-processed soda-lime float glass substrate (hereinafter referred to as glass substrate) 2A and a CIS based thin-film photovoltaic device 2 formed (through film deposition) on the tin-free side (air side) A of the substrate, or to a process for producing the module. As shown in Fig. 4, a CIS based thin-film photovoltaic module 1 is a structure composed of: a CIS based thin-film photovoltaic device of a multilayer structure constituted of a glass substrate 2A and, superposed thereon in the following order, an alkali barrier layer, a metallic back electrode layer 2B, a light absorption layer 2C made of a p-type semiconductor, a high-resistance buffer layer 2D, and a window layer 2E constituted of an n-type transparent conductive film (see Fig. 5); a cover glass 4 bonded to the upper side of the device with a plastic resin 3, e.g., a crosslinked EVA resin; a back sheet 5 and a junction box 6 having a cable attached thereto, the sheet 5 and the box 6 being disposed on the back side of the CIS based thin-film photovoltaic device; and a frame 8 attached to the periphery of those members through a sealing material 7.

The CIS based thin-film photovoltaic device 2 is a heterojunction thin-film solar cell employing a multinary-compound semiconductor thin film as a light absorption layer. In particular, the device 2 has a pn heterojunction with the light absorption layer of a p-type semiconductor, such as a Cu-III-VI₂ Group chalcopyrite semiconductor, e.g., copper indium diselenide (CISe), copper indium gallium diselenide (CIGSe), copper indium gallium diselenide-sulfide (CIGSSe), or copper indium gallium disulfide (CIGS), or copper indium gallium diselenide (CIGSe) having a thin film of copper indium gallium diselenide-sulfide (CIGSSe) as a surface layer.

The CIS based thin-film photovoltaic device 2 employs as the glass substrate a soda-lime float glass produced by the float process. Because the float-processed soda-lime float glass substrate (hereinafter referred to as glass substrate) 2A is produced by the float process, which comprises causing a molten glass to float on molten tin and regulating the floating glass so as to have a given thickness as shown in Fig. 6, the two surfaces of the glass substrate 2A are an air side which does not contain tin and a float side which contains tin. When a CIS based thin-film photovoltaic device 2 is formed on the float side, the following problem arises. In the step of depositing a light absorption layer for the CIS (CuInSe₂) type thin-film photovoltaic device, the tin diffuses into the light absorption layer during heating at 400-600°C. This does not result in the formation of chalcopyrite structure, which is a desirable crystal system (crystal structure), but results in the formation of a defective chalcopyrite structure or a stannite structure, which each is a crystal structure unsuitable for the production of high-efficiency solar cells. It is necessary to form the CIS based thin-film photovoltaic device 2 on the surface of the tin-free air side A of the glass substrate 2A.

CIS based thin-film photovoltaic devices 2 were formed on the tin-free air side A of a glass substrate 2A and electrically connected to each other (according to a connection pattern) (the photovoltaic devices thus connected are referred to as a circuit). Thus, circuits x were produced. Furthermore, circuits Y were produced by forming a circuit on the tin-containing float side B of each of glass substrates 2A. Two hundred and forty such circuits X and 240 such circuits Y were examined for conversion efficiency (property X and property Y). A comparative distribution diagram showing the results of the examination is given in Fig. 2. The results show that when the conversion efficiencies (property X) of the circuits X produced by forming (through film deposition) CIS based thin-film photovoltaic devices on the air side of each of glass substrates 2A are compared with the conversion efficiencies (property Y) of the circuits Y produced by forming (through film deposition) CIS based thin-film photovoltaic devices on the float side of each of glass substrates 2A, the circuits X are found to be distributed in a large number in a higher-conversion efficiency region than the circuits Y. Namely, the results demonstrate that the circuits X have a higher conversion efficiency than the circuits Y. The invention hence provides a CIS based thin-film photovoltaic device in which a CIS based thin-film photovoltaic device 2 has been formed (through film deposition) on the tin-free air side A of a float-processed soda-lime float glass substrate 2A as shown in Fig. 5, or provides a process for producing the module.

In forming a CIS based thin-film photovoltaic device 2 on a glass substrate 2A, it is necessary to first form a judgment as to whether the surfaces of the glass substrate 2A contain tin or not.

The process of the invention for producing a CIS based thin-film photovoltaic module includes a glass surface distinction step P1 before a glass cleaning/drying step P4. In the step P1, the air side A and float side B of a glass substrate 2A are distinguished from each other by a glass surface distinction device which forms a judgment as to whether each surface of the glass substrate 2A contains tin or not. The CIS based thin-film photovoltaic device 2 is then formed on the air side A.

After the glass surface distinction operation in which the air side A is distinguished in the glass surface distinction step P1, a tin containment mark indicating that tin is contained is quickly and accurately put on the float side B in a tin containment mark placement step P2. Specifically, the mark is put in a tin containment mark placement part P2 on an easily distinguishable part (peripheral or corner part) of the float side B with a material which is durable and does not disappear in later steps or by a method capable of forming such a durable mark. The mark may be a sign, e.g., a mark or a scar, formed on the glass surface by the application of a special coating material (e.g., a quick-drying fluorescent coating material), stamp printing with a special ink (e.g., a fluorescent ink), or application of an adhesive seal or the like bearing the mark printed thereon or with a laser, by sandblasting, with a scriber (diamond), etc. The mark may be a character, number, bar code, or another mark. This tin containment mark is put so that the presence thereof will be clear even after glass cleaning, whereby the quickness and accuracy of film deposition in later film deposition steps can be maintained (secured).

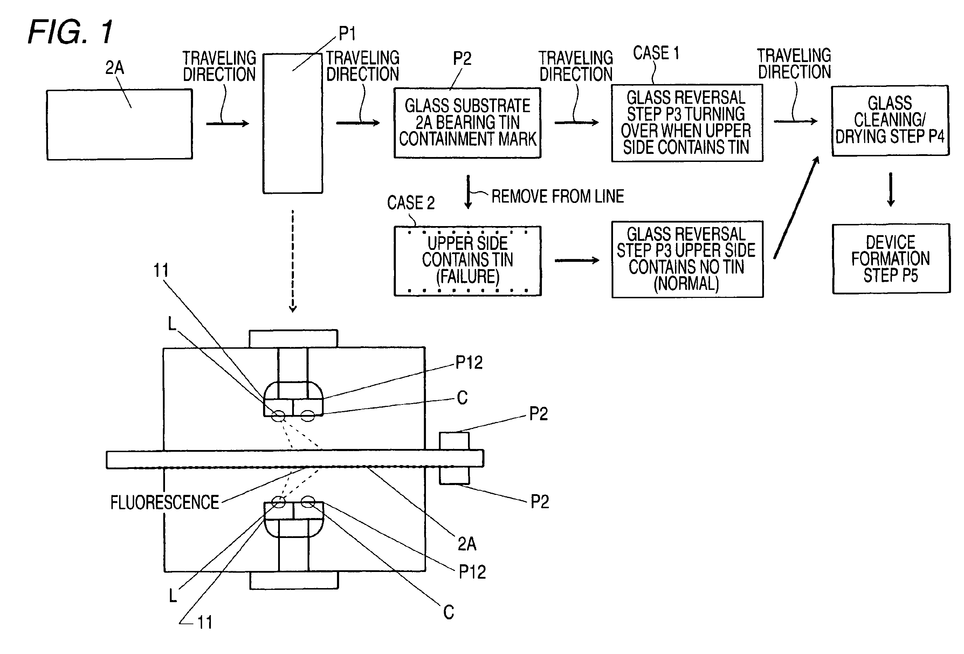

The glass surface distinction device P1 irradiates each surface of the glass substrate 2A with ultraviolet lights having a wavelength of 200-300 nm, preferably about 250-300 nm, which cause fluorescence in the presence of tin and do not penetrate the glass (are absorbed), by means of an ultraviolet lamp L as shown in Fig. 1. When the ultraviolet irradiation results in fluorescence (the amount of tin fluorescence is large (not smaller than a given value)), then this surface is judged to be the side where the CIS based thin-film photovoltaic device 2 is not to be formed. When the ultraviolet irradiation does not result in fluorescence (the amount of tin fluorescence is small (not larger than a given value)), then this surface is judged to be the side where the CIS based thin-film photovoltaic device 2 is to be formed. The fluorescence is received by a light-receiving element C, and whether tin is contained or not is judged based on output from the element C.

The glass substrates 2A to be introduced into the glass surface distinction step P1 are a givennumber of glass substrates cut into a given size and stacked so that the tin-free surface of each substrate in principle faces in any one of upward, downward, leftward, and rightward directions (upward direction in this embodiment) which is the side where a CIS based thin-film photovoltaic device 2 is to be formed (hereinafter referred to as deposition side). These glass substrates 2A are successively conveyed one by one to the glass surface distinction device P1, and the glass surface distinction device P1 forms a judgment as to whether the deposition side (the upper side in this embodiment) of each glass substrate 2A is the air side A or not. When the glass surface distinction device P1 judged the deposition side (the upper side in this embodiment) of a glass substrate 2A to be the air side A and a tin containment mark was put on that side of the glass substrate 2A on which a CIS based thin-film photovoltaic device 2 is not to be formed (hereinafter referred to as non-deposition side; the lower side in this embodiment) in the tin containment mark placement part P2, then this glass substrate 2A is conveyed to a reversal step P3 as the next step and is conveyed as it is to a glass cleaning/drying step P4 as the next step without being reversed (vertically or horizontally). On the other hand, when the glass surface distinction device P1 judged the non-deposition side (the lower side in this embodiment) of a glass substrate 2A to be the air side A and a tin containment mark was put on the deposition side (the upper side in this embodiment) of the glass substrate 2A in the tin containment mark placement part P2, then this glass substrate 2A is conveyed to a glass substrate reversal step P3 as the next step. This glass substrate 2A is reversed by rotating the substrate by 180° (vertically or horizontally; vertically in this embodiment) and conveyed to a glass cleaning/drying step P4 as the next step, with the air side as the deposition side (the upper side in this embodiment) (case 1).

Furthermore, there also is the following method. When the glass surf ace distinction device P1 judged the non-deposition side (the lower side in this embodiment) of a glass substrate 2A to be the air side A and a tin containment mark was put on the deposition side (the upper side in this embodiment) of the glass substrate 2A in the tin containment mark placement part P2, then this glass substrate 2A is removed from the conveyance line. Such glass substrates 2A removed are reversed by rotating these by 180° (vertically in this embodiment) and stacked so that the air sides thereof face in a given direction (case 2). As a result, the glass substrates 2A which have been removed and stacked can be stacked, with the tin-free surfaces thereof facing in a given direction. This stack as it is can be conveyed to a glass cleaning/drying step P4.

Incidentally in the glass surface distinction step P1, tin containment mark placement step P2, glass substrate reversal step P3, and glass substrate cleaning/drying step P4, the glass substrates 2A are arranged so that the air side A of each glass substrate 2A faces upward (the float side B faces downward) to constitute the deposition side. This is because the state in which the air side faces upward is convenient for apparatus arrangement and processing in later steps for CIS based thin-film photovoltaic device formation P5. However, the state of stacking of glass substrates 2A and the deposition side may be either horizontal or vertical. In this case, use may be made of a method in which the glass substrates 2A are arranged so that the air side A of each glass substrate 2A faces in a direction other than the upward direction in this embodiment, i.e., a downward, leftward, or rightward direction. A film deposition apparatus is disposed over or under the glass substrate 2A or on the left or right of the substrate 2A. As a result, the deposition side faces any of upward, downward, leftward, and rightward directions, while the non-deposition side faces in the direction opposite to that of the deposition side, i.e., any of downward, upward, rightward, and leftward directions.

The glass substrates 2A which have been cleaned/dried in the glass cleaning/drying step P4 are subjected, either successively or after temporary storage, to the processing P5 in which a CIS based thin-film photovoltaic device is formed on the air side of each glass substrate 2A.

Details of deposition steps P5 in producing the CIS based thin-film photovoltaic module are shown below.
As shown in Fig. 3, the deposition steps in producing the CIS based thin-film photovoltaic module comprise, in the following order, an alkali barrier layer deposition step, metallic-back-electrode layer deposition step, first pattern formation step, light absorption layer deposition step, high-resistance buffer layer deposition step, second pattern formation step, window layer deposition step, and third pattern formation step. After the deposition steps for forming a CIS based thin-film photovoltaic device, the work is further processed through a finishing step (formation of electrode parts), busbar ribbon soldering step, first output measurement step, packaging step, second output measurement step, test (pressure test, etc.) step, packing step, etc. in this order. Thus, a CIS based thin-film photovoltaic module is produced.

In part of the CIS based thin-film photovoltaic device formation steps P5, use may be made of a method in which a film is deposited on the air side A or deposition side of the glass substrate 2A while keeping the air side A in any one state selected from the states of facing upward, facing downward, facing in a lateral direction, and facing in a lateral direction inclined at a given angle. The direction in which the air side A or deposition side faces should not be construed as being used only in the CIS based thin-film photovoltaic device formation steps P5 in the invention, and may be used (employed) also in the preceding steps, i.e., the glass surface distinction step P1, tin containment mark placement step P2, glass substrate reversal step P3, and glass substrate cleaning/drying step P4.

### BRIEF DESCRIPTION OF THE DRAWINGS

[Fig. 1] Fig. 1 is a drawing showing a glass substrate front/back distinction step P1, a tin containment mark placement step P2, and a glass reversal step P3 in a process of the invention for producing a CIS based thin-film photovoltaic module.
[Fig. 2] Fig. 2 is a comparative distribution diagram showing the conversion efficiencies X of circuits X formed on the tin-free air sidesAof glass substrates 2A and the conversion efficiencies Y of circuits Y formed on the tin-containing float sides B of glass substrates 2A, in CIS based thin-film photovoltaic devices of the invention.
[Fig. 3] Fig. 3 is a diagram showing steps for producing a CIS based thin-film photovoltaic module of the invention.
[Fig. 4] Fig. 4 is a view showing the constitution of a CIS based thin-film photovoltaic module of the invention.
[Fig. 5] Fig. 5 is a view showing the constitution of a CIS based thin-film photovoltaic device.
[Fig. 6] Fig. 6 is a view showing a step for producing a float glass for use as the glass substrate of a CIS based thin-film photovoltaic module.

### DESCRIPTION OF REFERENCE NUMERALS AND SIGNS

- 1: CIS based thin-film photovoltaic module
- 2: CIS based thin-film photovoltaic device part
- 2A: glass substrate
- A: air side
- B: float side
- 2B: alkali barrier layer
- 2C: metallic back electrode layer
- 2D: light absorption layer
- 2E: buffer layer
- 2F: window layer
- 3: EVA resin
- 4: cover glass
- 5: back sheet
- 6: junction box with cable
- 7: sealing material
- 8: frame
- P1: glass surface distinction step
- P2: tin containment mark placement step
- P3: glass substrate reversal step
- P4: glass cleaning/drying step
- P5: CIS based thin-film photovoltaic device formation step
- P51: alkali barrier layer deposition step
- P52: metallic-back-electrode layer deposition step
- P53: first pattern formation step
- P54: light absorption layer deposition step
- P55: high-resistance buffer layer deposition step
- P56: second pattern formation step
- P57: window layer deposition step
- P58: third pattern formation step
- X: conversion efficiencies of circuits formed on tin-free air sides A of glass substrates 2A
- Y: conversion efficiencies of circuits formed on tin-containing float sides B of glass substrates 2A

## Claims

1. A CIS based thin-film photovoltaic module **characterized by** forming a CIS (CuInSe₂) based thin-film photovoltaic device on a soda-lime float glass which is a float glass and has surfaces comprising an air side containing no tin and a float side containing tin, wherein the photovoltaic device is formed on the air side of the soda-lime float glass.

2. A process for producing a CIS based thin-film photovoltaic module, **characterized by** forming through film deposition a CIS (CuInSe₂) based thin-film photovoltaic device on a soda-lime float glass which is a float glass and has surfaces comprising an air side containing no tin and a float side containing tin, wherein the photovoltaic device is formed on the air side of the soda-lime float glass.

3. The process for producing a CIS based thin-film photovoltaic module according to claim 2, wherein the tin-free air side of the soda-lime float glass is distinguished with a glass surface distinction device which forms a judgment as to whether each surface of the soda-lime float glass contains tin or not, and the CIS based thin-film photovoltaic device is formed on the air side.

4. The process for producing a CIS based thin-film photovoltaic module according to claim 3, wherein the tin-containing float side of the soda-lime float glass is distinguished with the glass surface distinction device, and a tin containment mark indicating that tin is contained is put on the float side with a tin containment mark placer (or a mark indicating that no tin is contained is put on the tin-free air side of the soda-lime float glass) quickly and accurately, and wherein the CIS based thin-film photovoltaic device is formed on the tin-free air side of the soda-lime float glass.

5. The process for producing a CIS based thin-film photovoltaic module according to claim 3 or 4, wherein the glass surface distinction device irradiates each surface of the soda-lime float glass with ultraviolet lights having a wavelength of 200-300 nm, preferably about 250-300 nm, which cause fluorescence in the presence of tin and do not penetrate the glass (are absorbed), and wherein when the irradiation with the ultraviolet lights results in fluorescence (the amount of tin fluorescence is large (not smaller than a given value)), then the device judges this surface to be the side wherein the CIS based thin-film photovoltaic device is not to be formed, and when the ultraviolet irradiation does not result in fluorescence (the amount of tin fluorescence is small (not larger than a given value)), then the device judges this surface to be the side wherein the CIS based thin-film photovoltaic device is to be formed.

6. The process for producing a CIS based thin-film photovoltaic module according to claim 3 or 4, wherein the tin containment mark is a sign, e.g., a mark or a scar, which withstands physical or chemical treatments in later steps and is mechanically or visually distinguishable, and is put on a given position in a peripheral part of the surface of the soda-lime float glass with an ink or a coating material, with a laser or a glass scriber (diamond), or by sandblasting or the like.

7. The process for producing a CIS based thin-film photovoltaic module according to claim 3, 4, or 5, wherein a given number of soda-lime float glasses cut into a given size are conveyed one by one to the glass surface distinction device, the soda-lime float glasses having been stacked so that the tin-free air side of each glass in principle faces in any one of upward, downward, leftward, and rightward directions (e.g., upward direction) which is the side where a CIS based thin-film photovoltaic device is to be formed (hereinafter referred to as deposition side), wherein the tin-containing float side of each soda-lime float glass is distinguished by the glass surface distinction device, wherein when that side of the soda-lime float glass on which a CIS based thin-film photovoltaic device is not to be formed (hereinafter referred to as non-deposition side; e.g., the lower side) was judged to be the float side by the glass surface distinction device, then this soda-lime float glass is conveyed to next steps (steps for forming a CIS based thin-film photovoltaic device), wherein when the deposition side (e.g., the upper side) of the soda-lime float glass was judged to be the float side by the glass surface distinction device, then this soda-lime float glass is reversed by rotating the glass by 180° (vertically or horizontally) and conveyed to the next steps or is removed from the conveyance line.

8. The process for producing a CIS based thin-film photovoltaic module according to claim 3, 4, 5, or 6, wherein a given number of soda-lime float glasses cut into a given size are conveyed one by one to the glass surface distinction device, the soda-lime float glasses having been stacked so that the tin-free air side of each glass in principle faces in any one of upward, downward, leftward, and rightward directions (e.g., upward direction) which is the side where a CIS based thin-film photovoltaic device is to be formed (hereinafter referred to as deposition side), wherein when that side of the soda-lime float glass on which a CIS based thin-film photovoltaic device is not to be formed (hereinafter referred to as non-deposition side; e.g., the lower side) was judged to be the float side by the glass surface distinction device, then a tin containment mark is put on the non-deposition side (e.g., the lower side) of the soda-lime float glass (or a mark indicating that no tin is contained is put on the tin-free surface of the soda-lime float glass) by the tin containment mark placer, wherein when the deposition side (e.g., the upper side) of the soda-lime float glass was judged to be the float side by the glass surface distinction device, then a tin containment mark is put on the deposition side (e.g., the upper side) of the soda-lime float glass (or a mark indicating that no tin is contained is put on the tin-free surface of the soda-lime float glass) by the tin containment mark placer, wherein when the non-deposition side (e.g., the lower side) of the soda-lime float glass bears the tin containment mark, then this soda-lime float glass is conveyed to next steps (a cleaning step and steps for forming a CIS based thin-film photovoltaic device), and wherein when the deposition side (e.g., the upper side) of the soda-lime float glass bears the tin containment mark, then this soda-lime float glass is reversed by rotating the glass by 180° (vertically or horizontally) and conveyed to the next steps or is removed from the conveyance line.

9. The process for producing a CIS based thin-film photovoltaic module according to claim 8, wherein the soda-lime float glass which has been removed from the conveyance line is reversed by rotating the glass by 180° (vertically or horizontally) and stacked.

10. The process for producing a CIS based thin-film photovoltaic module according to claim 2 or 3, wherein the CIS based thin-film photovoltaic device is formed by steps which comprise, in the following order, an alkali barrier layer deposition step, a metallic-back-electrode layer deposition step, a first pattern formation step, a light absorption layer deposition step, a high-resistance buffer layer deposition step, a second pattern formation step, a window layer deposition step, and a third pattern formation step.

11. The process for producing a CIS based thin-film photovoltaic module according to claim 10, wherein in part of the steps for forming the CIS based thin-film photovoltaic device, a film is deposited on the air side of the soda-lime float glass while keeping the air side in any one state selected from the states of facing upward, facing downward, facing in a lateral direction, and facing in a lateral direction inclined at a given angle.
